Europäisches Patentamt

European Patent Office

Office européen des brevets

(11) Publication number: **0 385 048**
**A1**

## EUROPEAN PATENT APPLICATION

(21) Application number: **89730219.6**

(22) Date of filing: **13.12.89**

(51) Int. Cl.⁵: **H01L 23/367, H01L 23/13**

The title of the invention has been amended (Guidelines for Examination in the EPO, A-III, 7.3).

(30) Priority: **20.01.89 JP 9885/89**

(43) Date of publication of application:
**05.09.90 Bulletin 90/36**

(84) Designated Contracting States:
**DE FR GB**

(71) Applicant: **MITSUBISHI MINING & CEMENT CO., LTD.**
**5-1, Marunouchi 1-chome Chiyoda-ku Tokyo 100(JP)**

(72) Inventor: **Hirai, Michio**
**966-32 Shimohujisawa**
**Irima-shi Saitama(JP)**

(74) Representative: **Goddar, Heinz J., Dr. et al**
**FORRESTER & BOEHMERT**
**Widenmayerstrasse 4/I**
**D-8000 München 22(DE)**

(54) **Substrate for hybrid integrated circuit and process for producing the same.**

(57) In a hybrid integrated circuit structure comprising a ceramic substrate having a hybrid integrated circuit including a circuit section which is liable to develop a lot of heat to become a higher temperature, the thickness of that portion of the ceramic substrate which has the circuit section liable to develop a lot of heat to become a higher temperature is significantly reduced. A heat dissipater or a cooling device is mounted on a back of the ceramic substrate at its thinner portion. The hybrid integrated circuit structure is produced by preparing a plurality of thinner ceramic substrate pieces; removing, with at least one of the ceramic substrate pieces being excluded, a portion of each of other ceramic substrate peices corresponding to a location having a circuit section which is liable to develop a lot of heat to become a higher temperature, thereby providing a cut-away portion, the printing of the circuit onto the ceramic substrate pieces being conducted before or after formation of the cut-away portion; bonding the at least one ceramic substrate piece having no cut-away portion to the ceramic substrate pieces having the cut-away portion by a bonding material to provide a hybrid integrated circuit board; and mounting a circuit component which is liable to develop a lot of heat to become a higher temperature onto the thinner portion of the hybrid integrated circuit substrate, and mounting a circuit component which develops no heat onto the thicker portion of the hybrid integrated circuit substrate, thereby forming a hybrid integrated circuit.

# HYBRID INTEGRATED CIRCUIT AND PROCESS FOR PRODUCING THE SAME

## BACKGROUND OF THE INVENTION

### FIELD OF THE INVENTION

The present invention relates to a hybrid integrated circuit and a process for producing the same, and more particularly, to a hybrid integrated circuit having a structure designed to dissipate a heat developed from a circuit section which is liable to develop a lot of heat and become a higher temperature.

### DESCRIPTION OF THE PRIOR ART

The conventional hybrid integrated circuit structure includes a circuit component (which will be also referred to as an electronic component) and a hybrid integrated circuit mounted on a ceramic substrate, particularly on an alumina substrate. Among the circuit components and the hybrid integrated circuits, there are those which are liable to develop a lot of heat and become a higher temperature and neverthless, the conventionally used ceramic substrate has a uniform thickness in a range of 0.4 mm to 1.0 mm, and in such conventional substrate, a heat dissipating property is not taken into consideration.

In forming a portion of the alumina substrate into a thinner structure, it has been proposed to use a cutting technique, for example.

Because the conventional ceramic substrate has a uniform thickness in the range of 0.4 mm to 1.0 mm, however, it has the following problem: Such a thicker ceramic substrate may shield a heat and would not sufficiently dissipate the heat developed from the circuit and the cicuit component. In common parlance, the thicker ceramic substrate is poor in heat dissipatability, thereby reducing the characteristics of the circuit or the circuit component.

In addition, another problem is to disturb the increase in degree of integration and the reduction in weight of the entire hybrid integrated circuit, because a circuit component which is apt to be influenced by the heat cannot be disposed in the vicinity of the curcuit or the circuit component which will develop a lot of heat to become an increased temperature.

The real situation is that even in the proposal to form a portion of the ceramic substrate such as the alumina substrate into a thinner structure, it is substantially impossible to achieve this by the cutting, and at present, there is no suitable processing method.

Thereupon, the present inventors have made various studies with the above problems in view and consequently, they have found that the above problems are solved by using a specified structure or a process for producing the same. On this bassis, the present invention has been accomplished.

## SUMMARY OF THE INVENTION

Therefore, it is an object of the present invention to provide an excellent hybrid integrated circuit having structure designed to dissipate a heat developed from a circuit saection which is liable to develop a lot of heat and become a higher temperature.

It is another object of the present invention to provide a process for producing a hybrid integrated circuit of the type described above.

To achieve the above objects, according to the present invention, there is provided a hybrid integrated circuit structure, comprising a ceramic substrate having a hybrid integrated circuit including a circuit section which is liable to develop a lot of heat to become a higher temperature, wherein the thickness of that portion of the ceramic substrate which has the circuit section liable to develop a lot of heat to become a higher temperature is significantly reduced.

In addition to the above construction, a heat dissipater or cooling means may be mounted on a back of the ceramic substrate at its thinner portion.

Further, according to the present invention, there is provided a process for producing a hybrid integrated circuit structure, comprising the steps of:

(a) preparing a plurality of thinner ceramic substrate piece ;

(b) removing, with at least one of the ceramic substrates being excluded, a portion of each of the ceramic substrate peices corresponding to a location having a circuit section which is liable to develop a lot of heat to become a higher temperature, thereby providing a cut-away portion, the printing of the circuit onto the ceramic substrate pieces being conducted before or after formation of the cut-away portion;

(c) bonding the at least one ceramic substrate piece having no cut-away portion with the ceramic substrate pieces having the cut-away portion by a bonding material to provide a hybrid integrated circuit substrate; and

(d) mounting a circuit component which is liable to develop a lot of heat to become a higher temperature onto the thinner portion of the hybrid integrated circuit substrate, and mounting a circuit component which develops no heat onto the thicker portion of the hybrid integrated circuit substrate, thereby forming a hybrid integrated circuit.

As used herein, the phrase "circuit section which is liable to develop a lot of heat to become a higher temperature" referers to a circuit wiring section and/or a circuit component stended by the generation of a lot of heat during operation of the hybrid integrated circuit. In addition, the phrase "significantly reduced" is used to means that the thickness of the ceramic substrate piece may vary as desired.

The circuit component and a thicker film technique which can be used are those conventionally commonly used.

A plurality of the ceramic substrate pieces used in the present invention are put one on another to form a multi-layer substrate, and the thickness of one ceramic substrate piece is required to be as thin as possible and may be in a range of 0.05 mm to 0.2 mm.

It is preferable that the number of the ceramic substrate pieces laminated one on another may be on the order of 8 to 10 with the thickness of 0.05 mm, and on the order of 4 to 5 with the thickness of 0.2 mm.

The removal of a portion of the ceramic substrate piece may be carried out by use of a laser or dies, or the combination thereof, whereby a predetermined number of cut or punched portions having a given size may be formed at given locations. In putting a plurality of the ceramic substrate pieces one on another to provide a substrate having a desired thickness, the ceramic substrate pieces having the cut portions removed therefrom as described above may be disposed at predetermined locations and laminated to the ceramic substrate piece having a circuit formed thereon, thereby providing a ceramic substrate having a thicker and a thinner portion.

In the present invention, the formation of the circuit may be conducted before or after provision of the cut-away portion in the ceramic substrate piece, but preferably after such provision.

In an alternative embodiment of the thus-obtained ceramic substrate piece, a circuit may be formed on both of a face and back of the substrate and in the interior thereof.

For the ceramic substrate piece, an alumina substrate piece is preferred, but other substrates can be employed if they are of a usually used type.

The ceramic substrate which may be used in the present invention comprises thinner ceramic substrate pieces laminated one on another. The lamination may be achieved by calcining of the thinner ceramic substrate pieces, after subjecting some of them to various types of thicker film printings as desired. Therefore, the substrate pieces include those printed and those not printed in a thicker film manner. Then, a bonding glass paste is printed onto the resulting substrate pieces. These individual layers are placed one on another and then calcined at a temperature in a range of 500 to 900°C, thereby providing a wired substrate including desired thicker film components thereon.

The printing of the bonding glass paste may be carried out on a portion or the entire surface of the substrate piece, but preferably, the bonding glass paste is mounted on the entire surface of the substrate piece.

Illustrative of the bonding glass pastes are a borosilicate glass, a crystallized glass and the like.

A circuit component such as an IC bare chip (which generates a heat during operation) is mounted in a recess, i.e., a thinner portion of the exposed portion of the surface of the thus-obtained wired substrate. Thereafter, the substrate may be sealed with a cover.

The hybrid integrated circuit having the circuit component mounted thereon may be as such, but a heat dissipater or a cooling device may be placed on a back thereof. Alternatively, the heat dissipater or cooling device may be mounted on the cover, or may be also used as a cover. This makes it possible to provide a further heat dissipating effect or a cooling effect.

Thus, since a portion of the ceramic substrate is formed thinner, and the electronic component which generates a lot of heat to become a higher temperature is mounted as a circuit component on such thinner portion, the heat generated from the electronic component can be dissipated through the thinner ceramic substrate portion without accumulation. Further, the provision of the heat dissipater or the cooling device ensures a further promoted coling effect. This prevents the heat-developted portion of the circuit from being increased in temeprature and hence, it is possible to keep such portion at a lower temperature, leading to a prevention of a reduction in properties of the circuit or the circuit component due to the increase in temperature. In addition, a circuit or a circuit component which is liable to be subjected to another thermal influence and reduced in properties when it is placed in close vicinity to the heat-developed circuit portion can be disposed in such heat-developed circuit portion. This makes it possible to provide an increase in integration and a reduction in weight of the entire hybrid integrated circuit and also to reduce the entire length of the circuit, thereby enabling a high-speed operation of the hybrid integrated circuit.

The hybrid integrated circuit structure of the present invention exhibits a further effect when a cooling device is mounted on the back of the thinner ceramic substrate piece in place of the heat dissipater as described above.

According to the producing process according to the present invention, a ceramic substrate having a thicker portion and a thinner portion can be readily formed by cutting away one thinner ceramic substrate piece by use of a cutting mean such as a laser, and laminating a plurality of the ceramic subsrate pieces one on another.

The above and other objects, features and advantages of the invention will become apparent from a reading of the following detailed description of the preferred embodiment, taken in conjunction with the accompanying drawings.


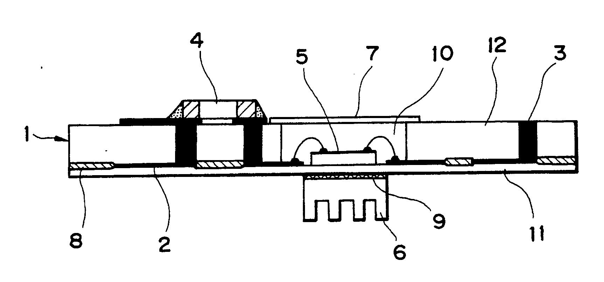

BRIEF DESCRIPTION OF THE DRAWING


Drawing is a sectional view of a hybrid integrated circuit structure according to the present invention.


DESCRIPTION OF THE PREFERRED EMBODIMENT


The present invention will now be described in detail by way of a preferred embodiment with reference to the accompanying drawing. This embodiment is illustrative, and the present invention is not intended to be limited thereto. The drawing is a sectional view of a hybrid integrated circuit according to the present invention. In the drawing, reference numeral 1 is a hybrid integrated circuit structure. First, a 0.05 mm thinner alumina substrate piece 11 is prepared. Another 1 mm thicker alumina substrate piece 12 is prepared, and a portion thereof corresponding to a location at which an electronic part (for example, an IC part) 5 is mounted is cut away by use of a laser cutter to provide a cut-away portion 10.

A conductive wiring 2 is mounted by a thicker film technique on each of the lower, thinner alumina substrate piece 11 having no cut-away portion and the upper, thicker alumina substrate piece 12 having the cut-away portion. The numer of the substrate pieces having conductive wirings 2 printed thereon by the thicker film technique is not limited to two, and wirings 2 can be printed onto a required number of the substrate pieces.

Then, the thicker alumina substrate piece 11 having the cut-away portion 10 thereon is placed onto the thinner alumina substrate piece 11 having the conductive wiring 2 and is bonded thereto by use of a glass binder 8 consisting of a glass adheive to provide an alumina wired substrate having the thinner alumina substrate piece 11 and the thicker alumina substrate piece 12.

Reference numeral 3 is a through hole used for connecting the individual wirings. A circuit component 4 developing no heat is mounted on the thicker alumina substrate piece of the alumina wired substrate provided in the above manner, and an electronic component 5 such as IC which is liable to develop a lot of heat and become a higher temperature is mounted on the thinner alumina substrate piece. A cover is mounted on the portion having the electronic component 5 such as IC.

The hybrid integrated circuit structure constructed in the above manner provides a heat dissipating effect as such, but according to the present invention, a heat dissipater 6 is further mounted on a back of the thinner alumina substrate piece having the electronic component such as IC, thereby providing a further heat dissipating effect. The heat dissipater 6 may be bonded using a heat resistant adhesive. The heat dissipater 6 can be replaced by a cooling device, and particularly when an electronic component exceeding the heat developing capacity is used, it is convenient to use the cooling device.


Claims

1. A hybrid integrated circuit structure, comprising a ceramic substrate having a hybrid integrated circuit including a circuit section which is liable to develop a lot of heat to become a higher temperature, wherein the thickness of that portion of the ceramic substrate which has the circuit section liable to develop a lot of heat to become a higher temperature is significantly reduced.

2. A hybrid integrated circuit structure according to claim 1, further including a heat dissipater or a cooling device mounted on a back of said ceramic substrate at its thinner portion.

3. A process for producing a hybrid integrated circuit structure, comprising the steps of:
(a) preparing a plurality of thinner ceramic substrate pieces;
(b) removing, with at least one of said ceramic substrate pieces being excluded, a portion of each of other ceramic substrate peices corresponding to a location having a circuit section which is liable to develop a lot of heat to become a higher temperature, thereby providing a cut-away portion, the printing of the circuit onto the ceramic substrate pieces being conducted before or after formation of the cut-away portion;
(c) bonding the at least one ceramic substrate piece having no cut-away portion to the ceramic substrate pieces having the cut-away portion by a bonding material to provide a hybrid integrated circuit board; and

(d) mounting a circuit component which is liable to develop a lot of heat to become a higher temperature onto the thinner portion of the hybrid integrated circuit substrate, and mounting a circuit component which develops no heat onto the thicker portion of the hybrid integrated circuit substrate, thereby forming a hybrid integrated circuit.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 10, no. 332 (E-453)(2388), 12 November 1986; & JP - A - 61 139 047 (TOSHIBA) 26.06.1986 | 1 | H 01 L 23/367 H 01 L 23/13 |
| Y | idem --- | 2,3 | |
| X | FR-A-2 554 275 (LA RTC) * page 1, paragraph 3; claims 1,4; figure 3 * --- | 1 | |
| Y | DE-A-3 030 763 (AMDAHL CORP.) * claim 1; page 9, last paragraph - page 10, second paragraph; figures 4,7 * --- | 2,3 | |
| A | DE-A-1 764 263 (SIEMENS AG) * page 2, paragraph 3 - page 4, paragraph 2; figure 2 * ----- | 1,2 | |
| | | | **TECHNICAL FIELDS SEARCHED (Int. Cl.5)** H 01 L 23/00 H 05 K 7/00 |

The present search report has been drawn up for all claims

| Place of search | Date of completion of the search | Examiner |
|---|---|---|
| BERLIN | 16-02-1990 | LE MINH I |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)